Europäisches Patentamt

European Patent Office

Office européen des brevets

(11) Publication number: **0 160 377**
**A1**

(12) **EUROPEAN PATENT APPLICATION**

(21) Application number: 85301907.3

(22) Date of filing: 19.03.85

(51) Int. Cl.⁴: **H 01 L 31/10**
**H 01 L 29/80, H 01 L 31/02**

(30) Priority: 28.03.84 US 594083

(43) Date of publication of application:
06.11.85 Bulletin 85/45

(84) Designated Contracting States:
DE FR GB IT NL

(71) Applicant: International Standard Electric Corporation
320 Park Avenue
New York New York 10022(US)

(72) Inventor: Ghosh, Chuni Lal
5954 Merriman Road
Roanoke Virginia 24018(US)

(72) Inventor: Phatak, Sunil Bhaskar
7216 Longleaf Drive N.W.
Roanoke Virginia 24019(US)

(74) Representative: Ruffhead, Philip Geoffrey
ITT-UK Patent Department Maidstone Road Foots Cray
Sidcup DA14 5HT(GB)

(54) Heterojunction photo-FET and method of making the same.

(57) A semiconductor device is fabricated on a substrate by initially forming a layer (2) of n-type InGaAs on one major surface of the substrate (1), followed by formation of either a layer or a gate (3) of p-type InGaAs, p-type InP or n-type InP on such n-type InGaAs layer, application of gate metallisation (4) to the layer or gate, removal of the material surrounding the gate, and formation of source and drain contacts (6 and 7) on the n-type InGaAs layer at mutually opposite sides of the gate. The semiconductor device can be used as a photodetector for light penetrating through the other major surface of the substrate toward the gate region.

Fig.2.

SEMICONDUCTOR DEVICE

The present invention relates to semiconductor devices in general, and more particularly to a semiconductor device incorporating indium gallium arsenide and to a method of manufacturing the same.

There are already known various constructions of semiconductor devices, usually made of silicon which is doped with various dopants to provide regions of different conductivity types. Also, various methods have been developed for fabricating such silicon semiconductor devices. However, experience has shown that such devices are rather slow because of the relatively low carrier mobility in silicon. On the other hand, attempts have already been made to make semiconductor devices by using gallium arsenide, and some high speed semiconductor devices have already been made using this material. Such devices are distinguished by speeds which are much higher than those achievable with similar devices made of silicon. However, experience has shown that even such gallium arsenide devices do not have the speed which is currently desired, for instance, for high speed communications.

Accordingly, it is an object of the invention to provide a semiconductor device which does not possess the above-enumerated disadvantages of known semiconductor devices.

Another object of the invention is so to construct the semiconductor device that it is able to operate at very high speeds.

It is another object of the invention so to design the semiconductor device that it is usable in a system using light, especially infrared light, as a transmission medium.

Another object of the invention is to develop a method of fabricating a semiconductor device of the above type, which method is relatively easy to perform and yet achieves reliable results.

According to one aspect of the invention there is provided a semiconductor device comprising a semiconductor substrate, characterised in that the device comprises a layer of n-type InGaAs on the substrate, at least one gate of a semiconductor material of one conductivity type on the layer, a metallic gate contact on the gate, and source and drain contacts arranged on the layer at mutually opposite sides of the gate.

A particular advantage of the construction of the semiconductor device as described so far is that indium gallium arsenide has even higher electron mobility than gallium arsenide, so that devices fabricated out of this material have much higher speeds than heretofore known. Moreover, this material has a lower band gap than gallium arsenide and, therefore, it is possible to fabricate semiconductor devices with lower resistivity ohmic contacts, higher transconductance, and lower noise, from this material. Moreover, because the band gap can be tailored by changing the composition of the material, such devices could also be used as infrared detectors in the regions of approximately 1.3 microns and 1.55 microns, which are the wavelengths at which lasers employed in fibre optic communication operate.

According to another aspect of the invention, there is provided a photodetector device comprising a semiconductor substrate at least translucent to radiation, especially infrared radiation, within a predetermined wavelength range and having two oppositely facing major surfaces, characterised in that it comprises a layer of n-type InGaAs absorbent of the radiation on one of the major surfaces of the substrate, at least one gate of a semiconductor material of one conductivity type on the layer, and source and drain contacts arranged on the layer at mutually opposite side of the gate in operation to induce an electric current flow through the layer past the gate, the magnitude of such current flow being dependent on the intensity of the radiation absorbed in the layer after passing through the substrate in the direction away from the other major surface of the latter.

According to another aspect of the invention there is provided a method of fabricating a photodetector device on a substrate that is at least translucent to radiation, especially infrared radiation, in a predetermined wavelength range, characterised in that it comprises the steps of forming a layer of n-type InGaAs absorbent of the radiation on one of oppositely-facing major surfaces of the substrate, applying at least one gate of a semiconductor material of one conductivity type to a gate region of the layer, and depositing a gate contact on the gate and source and drain contacts on the layer at mutually opposite sides of the gate, to induce in operation an electric current flow through the layer past the gate, the magnitude of such current flow being dependent on the intensity of the radiation absorbed in the layer after passing through the substrate in a direction away from the other major surface of the latter.

A device manufactured in accordance with this method can then be used for detecting the intensity of light reaching the device when it is incorporated, for instance, in an optic or communication system.

Embodiments of the invention will now be described by way of example with reference to the accompanying drawings, in which:

Figure 1 is a considerably enlarged cross sectional view through an incomplete semiconductor device according to the present invention during its fabrication;

Figure 2 is a view similar to that of Figure 1 but showing the completed device constructed as a junction field effect transistor (JFET) that can be used as a photodetector; and

Figure 3 is a view similar to that of Figure 2 but with the device being constructed as a MESFET.

The semiconductor device of the present invention can be constructed either as a JFET or as a MESFET. In each instance, the fabrication is commenced by growing a thin layer of n-type InGaAs on an insulating InP substrate. This layer has a thickness of substantially between .2 and .3 microns. The further fabricating steps, even though akin to one another, will differ for the JFET and for the MESFET, so that they will be hereafter discussed separately.

Starting with the fabrication of a JFET, the next following step after the formation of the n-type InGaAs layer is the growth of a p-type layer of either InGaAs or of InP on the n-type InGaAs layer. The thickness of this layer is approximately .2 to .3 microns.

After the growth of the p-type layer on the n-type InGaAs layer, the gate metallisation may be defined on the p-type layer by photolithography. Next, the gate metallisation is formed by evaporation of metals such as chromium followed by gold, these metals being suited for making ohmic contact to the p-type InGaAs and to the p-type InP as well. Thereafter, a protective layer of silicon dioxide is deposited on the gate metallisation.

Following the above discussed steps, the gate is defined by using conventional techniques, such as photolithography, and the material is etched either in a chemical etchant or by using plasma etching. When the p-type material is InGaAs, the progress of the etching is monitored very carefully and the etching is discontinued when the p-type layer of InGaAs has been removed at all other regions except beneath the gate metallisation. On the other hand, when the p-type material is InP, a selective etch is used which etches InP but does not etch InGaAs, so that the etching stops when the InGaAs layer is reached.

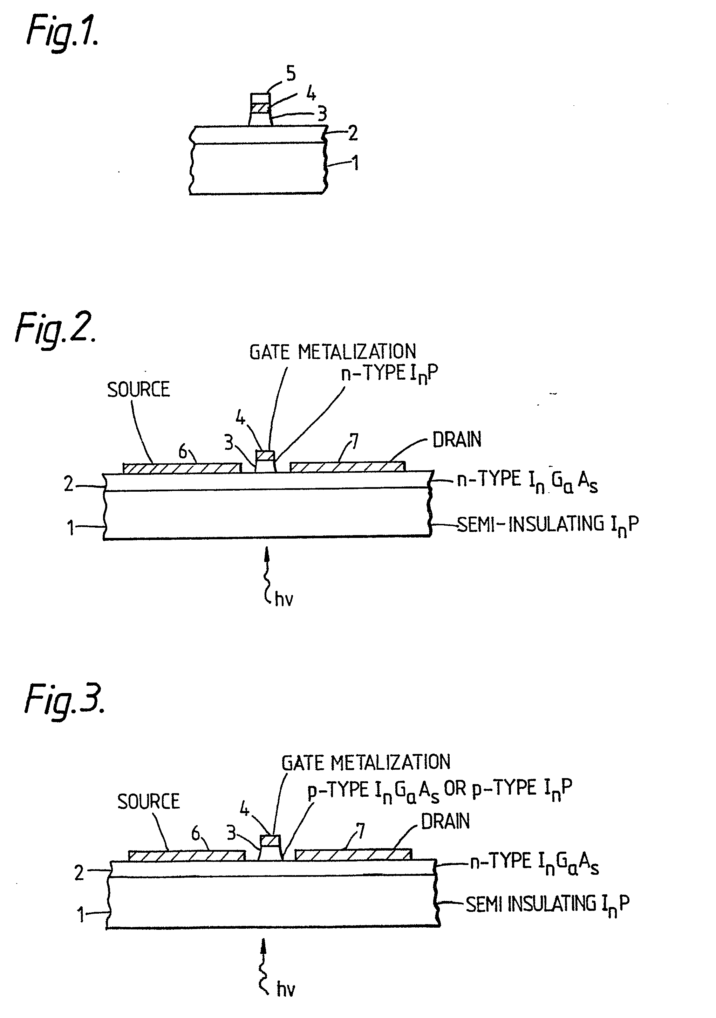

The incomplete device as it is constituted after any of these etching steps is shown in Figure 1. The reference numeral 1 has been used to identify a substrate of a substantially insulating or semi-insulating indium phosphide. The layer of n-type InGaAs deposited on the substrate 1 is identified by the reference to numeral 2. The gate formed on the substrate 1 is denoted by the reference numeral 3, while the reference numeral 4 identifies the gate metallisation, and the reference numeral 5 a protective layer of $SiO_2$. As mentioned before, the gate 3 is constituted by p-type InGaAs or p-type InP.

In the next step, source and drain contacts are formed on the n-type InGaAs layer by first resorting to the well known photolithographic technique, and then depositing the ohmic contact metallisation, such as AuGe/Ni. The formation thus obtained is then put through a thermal cycle for alloying the gate and source and drain metallisation. Finally, the $SiO_2$ layer 5 covering the gate 3 is removed by a short rinse in diluted hydrochloric acid.

The completed device as it appears after the last mentioned etching step is illustrated in Figure 2. It may be seen that the substrate 1 and the n-type InGaAs layer 2, as well as the gate 3 and the gate metallisation 4, are present in this structure as they were in the structure revealed in Figure 1. However, a source contact 6 and a drain contact 7 have been formed on the layer 2 in the above discussed manner, and the protective layer 5 of silicon dioxide has been removed from the gate contact 4.

The indium phosphide substrate 1 is transparent to infrared radiation in the range between approximately 1.2 and 1.6 microns which is used nowadays in optical fibre communication. On the other hand, the n-type InGaAs absorbs such radiation with attendant change in the flow of electric current between the source contact 6 and the drain contact 7 in dependence on the intensity ofthe radiation, provided that such radiation is directed through the substrate 1 toward the region of the gate 3. Hence, under such circumstances, the output of the JFET will be proportional to the intensity of such radiation.

In a variation of the process, a layer of silicon dioxide is deposited on the layer 2 of n-type InGaAs before any other deposition takes place. Then, the region for the gate 4 is opened in the silicon dioxide layer by etching or lift-off. Then, the p-type InGaAs or InP is grown on these areas by selective epitaxy. Then, the following steps starting with the deposition of the gate metallisation 4 are performed in the same manner as described above.

When the device to be fabricated is to be MESFET, which would normally not be possible on InGaAs provided on a lower band gap material because the Schottky barrier height would be too low, in the order of about .3eV, it is advantageous to proceed according to the present invention in the following manner:

A lattice-matched InP of the n-conductivity type, lightly doped, is grown on the previously provided layer 2 of n-type InGaAs. This layer increases the Schottky barrier height.

In the next step, gate metallisation is defined on the n-type InP. In this instance, the gate metallisation which is deposited consists of such materials as aluminium or Mo/Au which do not react with InP at high temperatures. Thereafter, the gate metallisation is protected by a layer of silicon dioxide on top. The incomplete device thus formed is then etched by a selective etch to remove the InP layer everywhere but underneath the gate metallisation. When the thin layer of InP is completely etched except at those regions that are situated below the gate metallisation, ohmic metallisation for source and drain contacts is defined by evaporating material such as Au/Ge/Ni on the layer 2 of n-type InGaAs and alloying it at a high temperature. The fabrication of the device is then completed by etching the silicon dioxide protective layer from the gate metallisation, similarly to what has been described above in connection with the JFET.

The completed device is shown in Figure 3 where the same reference numerals as before have been used to identify the corresponding parts or regions. The device of Figure 3 differs from that of Figure 2 in that the gate 3 is of an n-type material, that is, n-type InP.

Here again, the gate 3 may be fabricated in the manner described above as an alternative, that is, by depositing a layer of $SiO_2$ on the layer 2 of n-type InGaAs, by opening a window in the gate region by lift-off or chemical etching, and by growing n-type InP on the open areas by selective epitaxy. Of course, here again, the following steps commencing with deposition of the gate metallisation will be the same as in the above discussed process. The MESFET device constructed in this manner is also suited for use as a photodetector, for the same reasons as discussed above in connection with the JFET device, and in the same manner.

The various steps discussed above are known in principle, even though used in prior art to form different devices. Therefore, it is not necessary to discuss such steps, such as photolithography, lift-off, growing of material layers, etching, and the like, here, since such individual steps are well known to those active in this field. On the other hand, the succession of steps described here, using

- 9 -

0160377

specific materials at specified regions, is unique to the present invention, and so are the semiconductor devices presented here.

- 10 -    0160377

<u>CLAIMS</u>:

1. A semiconductor device comprising a semiconductor substrate, characterised in that the device comprises a layer of n-type InGaAs on the substrate, at least one gate of a semiconductor material of one conductivity type on the layer, a metallic gate contact on the gate, and source and drain contacts arranged on the layer at mutually opposite sodes of the gate.

2. A semiconductor device as claimed in claim 1, characterised in that the substrate is of a substantially-insulating InP.

3. A semiconductor device as claimed in claim 1, characterised in that the one conductivity type of the semiconductor material of the gate is the p-type.

4. A semiconductor device as claimed in claim 3, characterised in that the semiconductor material of the gate is InP.

5. A semiconductor device as claimed in claim 3, characterised in that the semiconductor material of the gate is InGaAs.

6. A semiconductor device as claimed in claim 1, characterised in that the one conductivity type of the semiconductor material of the gate is the n-type.

7. A semiconductor device as claimed in claim 6, characterised in that the semiconductor material of the gate is InP.

8. A semiconductor device as claimed in claim 1 for use in detecting radiation, especially infrared radiation, within a predetermined wavelength range, characterised in that the substrate is at least translucent to, and the layer substantially absorbs, the radiation, so that such radiation passes through the substrate to reach the layer and be absorbed therein with attendant change in the magnitude of the electric current flowing through the layer between the source and drain contacts in dependence on the intensity of the radiation.

9. A photodetector device comprising a semiconductor substrate at least translucent to radiation, especially infrared radiation, within a predetermined wavelength range and having two oppositely facing major surfaces, characterised in that it comprises a layer of n-type InGaAs absorbent of the radiation on one of the major surfaces of the substrate, at least one gate of a semiconductor material of one conductivity type on the layer, and source and drain contacts arranted on the layer as mutually opposite side of the gate in operation to induce an electric current flow through the layer past the gate, the magnitude of such current flow being dependent on the intensity of the radiation absorbed in the layer after passing through the substrate in the direction away from the other major surface of the latter.

10. A photodetector device as claimed in claim 9, characterised in that the substrate is of a substantially insulating InP.

11. A photodetector device as claimed in claim 9, characterised in that the semiconductor material of the gate is of the p-type.

12. A photodetector device as claimed in claim 11, characterised in that the semiconductor material of the gate is InP.

13. A photodetector device as claimed in claim 11, characterised in that the semiconductor material of the gate is InGaAs.

14. A photodetector device as claimed in claim 9, characterised in that the one conductivity type of the semiconductor material of the gate is n-type.

15. A photodetector device as claimed in claim 14, characterised in that the semiconductor material of the gate is InP.

16 A method of fabricating a photodetector device on a substrate that is at least translucent to radiation, especially infrared radiation, in a predetermined wavelength range, characterised in that it comprises the steps of forming a layer of n-type InGaAs absorbent of the radiation on one of oppositely-facing major surfaces of the substrate, applying at least one gate of a semiconductor material of one conductivity type to a gate region of the layer, and depositing a gate contact on the gate and source and drain contacts on the layer at mutually opposite sides of the gate, to induce in operation an electric current flow through the layer past the gate, the magnitude of such current flow being dependent on the intensity of the radiation absorbed in the layer after passing through the substrate in a direction away from the other major surface of the latter.

**Fig.1.**

**Fig.2.**

**Fig.3.**

## DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| X | ELECTRONICS INTERNATIONAL, vol. 56, no. 7, 7th April 1983, pages 88-90, New York, US; R.T. GALLAGHER: "Single process for FETs and transistors may lead to single-chip GaAs photoreceivers" * Figures; page 88, last paragraph - page 90, first and second paragraph * | 1-3,5, 8,9-11 ,13,16 | H 01 L 31/10<br>H 01 L 29/80<br>H 01 L 31/02 |
| | --- | | |
| X | EP-A-0 055 968 (THOMSON-CSF) * Figure 9; page 7; claims 4,7,8; page 9, line 15 * | 1,2,6, 7 | |
| A | | 9,10, 14-16 | |
| | --- | | TECHNICAL FIELDS SEARCHED (Int. Cl.4) |
| X | FR-A-2 517 888 (WESTERN ELECTRIC COMP. INC.) * Figure 4; page 4, line 11 - page 5, line 1; page 8, lines 4-22 * | 1-3,5 | H 01 L |
| A | | 9-11, 13,16 | |
| | --- | | |
| A | GB-A-2 109 991 (STANDARD TELEPHONES AND CABLES LTD.) * Page 1, lines 57-77 * | 1-4,9- 12,16 | |
| | --- -/- | | |

The present search report has been drawn up for all claims

| Place of search | Date of completion of the search | Examiner |
|---|---|---|
| THE HAGUE | 27-06-1985 | PRETZEL B.C. |

European Patent Office

**EUROPEAN SEARCH REPORT**

**0160377**
Application number

EP 85 30 1907

Page 2

## DOCUMENTS CONSIDERED TO BE RELEVANT

| Category | Citation of document with indication where appropriate, of relevant passages | Relevant to claim | CLASSIFICATION OF THE APPLICATION (Int Cl 4) |
|---|---|---|---|
| A | IEEE JOURNAL OF QUANTUM ELECTRONICS, vol. QE-19, no. 6, June 1983, pages 1134-1138, IEEE, New York, US; J.C. CAMPBELL et al.: "Avalanche InP/InGaAs heterojunction phototransistor" * Figure 1 * | 1,8 | |
| A | GALLIUM ARSENIDE AND RELATED COMPOUNDS, 1980, 22nd-24th September 1980, no. 56, pages 465-473, Institute of Physics, London, GB; H. OHNO et al.: "Double heterostructure Ga0.47In0.53As MESFETs by molecular beam epitaxy" | | |

TECHNICAL FIELDS
SEARCHED (Int. Cl.4)

The present search report has been drawn up for all claims

| Place of search THE HAGUE | Date of completion of the search 27-06-1985 | Examiner PRETZEL B.C. |
|---|---|---|